(19) Europäisches Patentamt
European Patent Office
Office européen des brevets

(11) EP 4 549 996 A1

(12) EUROPEAN PATENT APPLICATION

(43) Date of publication:
07.05.2025 Bulletin 2025/19

(21) Application number: 24199782.4

(22) Date of filing: 11.09.2024

(51) International Patent Classification (IPC):
G01S 7/4865 (2020.01)     G01S 7/487 (2006.01)
G01S 17/10 (2020.01)      G01S 7/4861 (2020.01)

(52) Cooperative Patent Classification (CPC):
G01S 7/4865; G01S 7/4861; G01S 7/487;
G01S 17/10

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 30.10.2023 US 202318498010

(71) Applicant: Avago Technologies International
Sales
Pte. Limited
Singapore 768923 (SG)

(72) Inventors:
• Enne, Reinhard
  3202 Hofstetten-Gruenau (AT)
• Davidovic, Milos
  1110 Vienna (AT)
• Gaberl, Wolfgang
  1220 Vienna (AT)

(74) Representative: Dilg, Haeusler, Schindelmann
Patentanwaltsgesellschaft mbH
Leonrodstraße 58
80636 München (DE)

(54) **SYSTEMS AND METHODS FOR SIGNAL PROCESSING IN LIGHT DETECTION AND RANGING (LIDAR) SYSTEMS**

(57) The subject technology is directed to light detection and ranging (LIDAR) systems and methods. In an embodiment, the subject technology provides a device comprising an optical module configured to receive a first optical signal and a first circuit configured to generate a first electrical signal based on the first optical signal. The device also comprises a first comparator configured to generate a second electrical signal by comparing the first electrical signal to a first threshold value. The device further comprises a first filter configured to generate a first pulse based on the second electrical signal. The first pulse comprises a first point associated with a first timestamp. The timestamp data may be briefly retained in the analog domain, followed by subsequent digital conversion, allowing for significant power savings and reduced system bandwidth. There are other embodiments as well.

Fig. 1

EP 4 549 996 A1

## Description

FIELD OF INVENTION

The subject technology is directed to systems and methods for light detection and ranging (LIDAR) technologies.

BACKGROUND OF THE INVENTION

Over the past decades, the advancements in remote sensing technologies have propelled systems into a heightened level of environmental responsiveness. These technologies equip systems with the capability to comprehend, interpret, and interact with their surroundings. Various approaches involve laser-based sensing techniques, such as light detection and ranging (LIDAR) applications, which can provide high-resolution environmental data (e.g., depth maps) to indicate the proximity of different objects to the LIDAR device. For instance, LIDAR devices-which may utilize single-pixel or multi-pixel sensors-can probe depths reaching hundreds of meters, ensuring accuracy within a narrow margin. To match such precision standards, LIDAR pulse durations are fine-tuned to mere nanoseconds. This necessitates corresponding system frontends, especially those tethered to light-sensitive detectors, to maintain high bandwidth. Given substantial bandwidth constraints, it remains a challenging task to effectively manage signal processing over numerous channels and achieve seamless integration of various system components.

Various approaches for optimizing signal processing for LIDAR applications have been explored, but they have proven to be insufficient. It is important to recognize the need for new and improved systems and methods for LIDAR applications.

BRIEF DESCRIPTION OF THE DRAWINGS

A further understanding of the nature and advantages of particular embodiments may be realized by reference to the remaining portions of the specification and the drawings, in which like reference numerals are used to refer to similar components. In some instances, a sub-label is associated with a reference numeral to denote one of multiple similar components. When reference is made to a reference numeral without specification to an existing sub-label, it is intended to refer to all such multiple similar components.

Figure 1 is a simplified diagram illustrating a LIDAR system according to embodiments of the subject technology.

Figure 2 is a simplified diagram illustrating a signal processing scheme of a LIDAR system according to embodiments of the subject technology.

Figure 3 is a simplified diagram illustrating a signal processing scheme of a LIDAR system according to embodiments of the subject technology.

Figure 4 is a simplified diagram illustrating an analog implementation of a signal processing scheme of a LIDAR system according to embodiments of the subject technology.

Figure 5 is a simplified diagram illustrating an analog implementation of a signal processing scheme of a LIDAR system according to embodiments of the subject technology.

Figure 6 is a simplified diagram illustrating a filter of a LIDAR system according to embodiments of the subject technology.

DETAILED DESCRIPTION OF THE INVENTION

The subject technology is directed to light detection and ranging (LIDAR) systems and methods. In an embodiment, the subject technology provides a device comprising an optical module configured to receive a first optical signal and a first circuit configured to generate a first electrical signal based on the first optical signal. The device also comprises a first comparator configured to generate a second electrical signal by comparing the first electrical signal to a first threshold value. The device further comprises a first filter configured to generate a first pulse based on the second electrical signal. The first pulse comprises a first point associated with a first timestamp. The timestamp data may be briefly retained in the analog domain, followed by subsequent digital conversion, allowing for significant power savings and reduced system bandwidth. There are other embodiments as well.

As is known, a time-of-flight (ToF) LIDAR system operates by transmitting a beam of light towards a target object and then waiting to receive a reflected portion of the emitted light after reflection by the target object. The elapsed time between the transmission and reception of the light beam is used to calculate the distance between the LIDAR system and the target object. Such systems utilize what are commonly referred to as direct ToF calculations, as they rely directly on the time of flight to determine distance. Direct ToF LIDAR systems often focus on discerning the arrival time of signal echoes, which requires differentiating these echoes from other noises. The term "signal echo" or "echo signal" may refer to reflections of the transmitted optical signals that bounce back to the sensor after hitting the object. For instance, a LIDAR system may be attuned to its associated analog-to-digital converter (ADC) in such a way that it emphasizes the efficient detection of these echo signals. This is to ensure the accuracy of distance measurements and promote high-resolution imaging. However, striking the balance between efficiency and accuracy can be challenging due to the presence of noise. The term "noise" may encompass all forms of unrelated signals, which could originate from various sources like background light, detector disturbances, dark counts, and/or amplifier disruptions.

Due to the intricate nature of signal processing-where multiple signal echoes are evaluated in a constrained timeframe-temporal constraints become an important aspect of LIDAR design. These time-sensitive limitations can determine how well a LIDAR system can discern between closely spaced objects. Moreover, considerations become more intricate when taking into account the amplitude variations of the received echo signals. For example, certain objects may produce weaker reflections compared to others, introducing variations in the amplitude of returned signals, which can complicate the signal discrimination process.

In various embodiments, the subject technology provides LIDAR systems that effectively tackle the challenges of closely spaced object discrimination without compromising signal fidelity or detection efficiency. This is achieved by introducing a series of adaptive thresholds in the ADC that span a broad amplitude range, ensuring that echoes from both near and far objects are detected with high fidelity. With this adaptability in threshold settings, LIDAR systems can be designed to be more versatile, and capable of operating in varied environments-from dense urban settings to open terrains. Through the adaptive selection of these thresholds, LIDAR systems can achieve shorter processing times, elevating both signal quality and the rate of data acquisition. Additionally, the results of echo signal evaluation can be temporarily stored within the analog domain using analog storage elements such as capacitors or inductors. This transient analog retention can subsequently result in deferred digitization, thereby mitigating the rigorous performance requirements on data interconnections and the ADCs. Embodiments of the subject technology provide LIDAR systems with enhanced operational efficiency, marked by faster response times and lower energy demands.

The following description is presented to enable one of ordinary skill in the art to make and use the invention and to incorporate it in the context of particular applications. Various modifications, as well as a variety of uses in different applications, will be readily apparent to those skilled in the art, and the general principles defined herein may be applied to a wide range of embodiments. Thus, the subject technology is not intended to be limited to the embodiments presented but is to be accorded the widest scope consistent with the principles and novel features disclosed herein.

In the following detailed description, numerous specific details are set forth in order to provide a more thorough understanding of the subject technology. However, it will be apparent to one skilled in the art that the subject technology may be practiced without necessarily being limited to these specific details. In other instances, well-known structures and devices are shown in block diagram form, rather than in detail, in order to avoid obscuring the subject technology.

The reader's attention is directed to all papers and documents which are filed concurrently with this specification and which are open to public inspection with this specification, and the contents of all such papers and documents are incorporated herein by reference. All the features disclosed in this specification, (including any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Furthermore, any element in a claim that does not explicitly state "means for" performing a specified function, or "step for" performing a specific function, is not to be interpreted as a "means" or "step" clause as specified in 35 U.S.C. Section 112, Paragraph 6. In particular, the use of "step of" or "act of" in the Claims herein is not intended to invoke the provisions of 35 U.S.C. 112, Paragraph 6.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Similarly, when an element is referred to herein as being "bonded" to another element, it is to be understood that the elements can be directly bonded to the other element (without any intervening elements) or have intervening elements present between the bonded elements. In contrast, when an element is referred to as being "directly bonded" to another element, it should be understood that no intervening elements are present in the "direct" bond between the elements. However, the existence of direct bonding does not exclude other forms of bonding, in which intervening elements may be present.

Likewise, when an element is referred to herein as being a "layer," it is to be understood that the layer can be a single layer or include multiple layers. For example, a conductive layer may comprise multiple different conductive materials or multiple layers of different conductive materials, and a dielectric layer may comprise multiple dielectric materials or multiple layers of dielectric materials. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require the selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

One general aspect includes a device comprising an optical module configured to receive a first optical signal. The device further comprises a first circuit coupled to the optical module; the first circuit being configured to generate a first electrical signal based on at least the first optical signal. The device further comprises a first comparator coupled to the first circuit, the first comparator being configured to generate a second electrical signal by comparing the first electrical signal to a first threshold value. The device further comprises a first filter coupled to the first comparator, the first filter being configured to generate a third electrical signal based on at least the second electrical signal. The third electrical signal comprises a first pulse, the first pulse comprises a first point associated with a first timestamp. The device further comprises a second circuit coupled to the first filter, the second circuit being configured to generate a fourth electrical signal based on at least the first pulse. The device further comprises a memory configured to receive the fourth electrical signal and store the first timestamp.

Implementations may include one or more of the following features. The device further comprises a second comparator coupled to the first circuit, the second comparator being configured to compare the first electrical signal to a second threshold value. The device further comprises a second filter coupled to the second comparator. The memory comprises a capacitor or an inductor. The device further comprises a third circuit coupled to the memory, the third circuit being configured to read the first timestamp and to send a first signal to the second circuit to reset the memory. The first pulse comprises a rising pulse in response to the first electrical signal being higher than the first threshold value. The first pulse comprises a falling pulse in response to the first electrical signal being lower than the first threshold value. The first filter is configured to determine a width of the first pulse. The device further comprises a fourth circuit coupled to the first comparator, the fourth circuit being configured to adjust the first threshold value. The fourth electrical signal comprises an analog signal.

According to another embodiment, the subject technology provides a device comprising an optical module configured to receive a first optical signal. The device further comprise a first circuit coupled to the optical module, the first circuit being configured to generate a first electrical signal based on at least the first optical signal. The device further comprises a first comparator coupled to the first circuit, the first comparator being configured to generate a second electrical signal by comparing the first electrical signal to a first threshold value. The device further comprises a first filter coupled to the first comparator, the first filter being configured to generate a third electrical signal based on at least the second electrical signal, the third electrical signal comprising a first pulse, the first pulse comprising a first point associated with a first timestamp. The device further comprises a second circuit coupled to the first filter, the second circuit being configured to generate a fourth electrical signal based on at least the first pulse. The device further comprises a memory coupled to the second circuit, the memory being configured to receive the fourth electrical signal and store the first timestamp.

Implementations may include one or more of the following features. The device further comprises a second comparator coupled to the first circuit, the second comparator being configured to generate a fifth electrical signal by comparing the first electrical signal to a second threshold value. The device further comprises a second filter coupled to the second comparator, the second filter being configured to generate a sixth electrical signal based on at least the fifth electrical signal, the sixth electrical signal comprising a second pulse, the second pulse comprising a second point associated with a second timestamp. The device further comprises a fourth circuit coupled to the second filter, the fourth circuit being configured to generate a seventh electrical signal based on at least the second pulse. The memory is coupled to the fourth circuit, and the memory is configured to receive the seventh electrical signal and store the second timestamp. The device further comprises a fifth circuit coupled to the first comparator, the fifth circuit being configured to adjust the first threshold value.

According to yet another embodiment, the subject technology provides a device comprising an optical module configured to receive a first optical signal. The device further comprises a first circuit coupled to the optical module, the first circuit being configured to generate a first electrical signal based on at least the first optical signal. The device further comprises a first comparator coupled to the first circuit, the first comparator being configured to generate a second electrical signal by comparing the first electrical signal to a first threshold value. The device further comprises a first filter coupled to the first comparator, the first filter being configured to generate a third electrical signal based on at least the second electrical signal, the third electrical signal comprising a first pulse, the first pulse comprising a first point and a second point, the first point being associated with a first timestamp, the second point being associated with a second timestamp. The device further comprises a second circuit coupled to the first filter, the second circuit being configured to generate a fourth electrical signal based on at least the first pulse. The device further comprises a memory configured to receive the fourth electrical signal and store a third timestamp based on at least the first timestamp and the second timestamp.

Implementations may include one or more of the following features. The first pulse further comprises a third point positioned between the first point and the second point, the third point is associated with the third timestamp. The memory comprises a capacitor or an inductor. The device further comprises a third circuit coupled to the memory, the third circuit being configured to read the third timestamp. The fourth electrical signal comprises an analog signal.

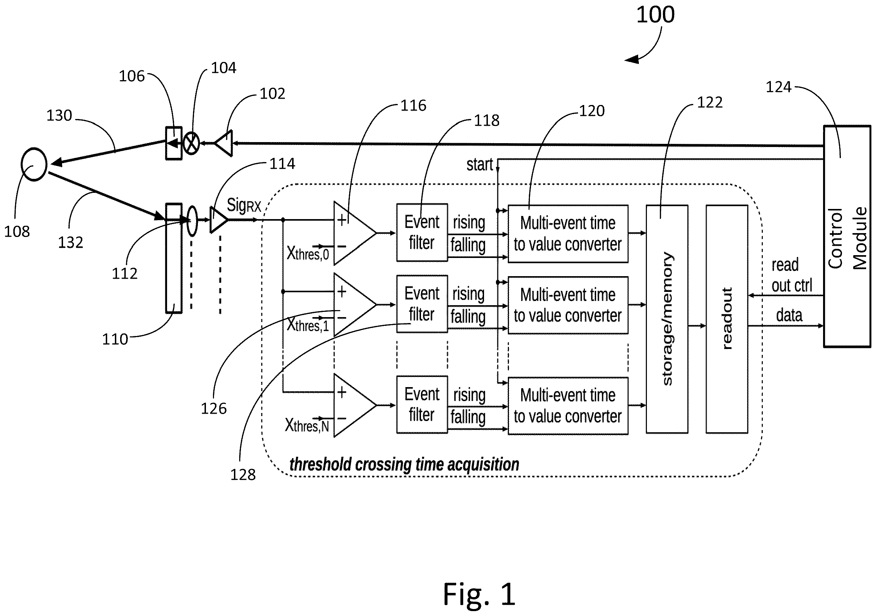

Figure 1 is a simplified diagram illustrating a LIDAR system 100 according to embodiments of the subject technology. This diagram merely provides an example, which should not unduly limit the scope of the claims. One of ordinary skill in the art would recognize many variations, alternatives, and modifications.

As shown, LIDAR system 100 may include at least one of a light source 104, a driver 102, a transmitter module 106, a receiver module 110, a detector 112, a frontend 114, and a control module 124. In operation, light source 104 emits a light beam 130 through transmitter module 106. Light source 104 may include any device capable of producing light of specific wavelengths in the infrared, visible, or ultraviolet portions of the electromagnetic spectrum. For example, light source 104 includes, but is not limited to, an edge-emitting laser (EEL), a quantum well laser, a distributed Bragg reflector (DBR) laser, a distributed feedback (DFB) laser, a vertical cavity surface emitting laser (VCSEL), a pulsed solid-state laser, a pulsed fiber laser, and/or the like. Depending on the implementation, the light beam 130 may be continuous-wave, pulsed, or modulated. For instance, light source 104 includes a pulsed laser or a pulsed light-emitting diode (LED) configured to emit light pulses with a certain pulse duration (e.g., less than 20 nanoseconds). Transmitter module 106 may include one or more optical or electrical elements (e.g., lenses, bandpass filters, interference filters, beam splitters, polarizers, modulators, or amplifiers) to ensure that light beam 130 is appropriately shaped, focused, and directed to maximize the range and accuracy of the LIDAR system 100.

In some embodiments, driver 102 is coupled to light source 104 and is configured to supply and modulate the electrical current or voltage to drive light source 104. Driver 102 can control various attributes of light beam 130, such as its width, shape, frequency, and amplitude. In some cases, this modulation is governed by control module 124 and is tailored to meet the specific implementation requirements of the LIDAR system 100 (e.g., power, distance, and resolution).

In some embodiments, light beam 130 upon reaching target 108, is reflected. Target 108 can be located at a certain distance from LIDAR system 100, potentially up to several hundred meters. Target 108 may reflect at least a portion of light from light beam 125, and some of the reflected light may return to LIDAR system 100. For instance, the reflected light-represented by optical signal 132 (e.g., the first optical signal recited in claim 1)-may be received by receiver module 110 (e.g., the optical module recited in claim 1). The term "optical signal" may refer to a light beam emitted by a light source of a LIDAR system and reflected to the system by the target object. The optical signal in a LIDAR system is characterized by its wavelength, pulse width, power, and polarization. The optical signal can used to determine the distance between the LIDAR system and the target object, as well as the physical properties of the object, such as its shape and texture.

In various implementations, receiver module 110 may include one or more optical or electrical elements (e.g., lenses, bandpass filters) to efficiently capture and channel the reflected optical signal 132 onto detector 112. Detector 112 (e.g., a first circuit recited in claim 1) may include an electronic component configured to receive optical signal 132 and generate a corresponding electrical signal. For instance, detector 112 includes, but is not limited to, an indirect band gap based detectors like avalanche photodiode (APD), a single-photon avalanche diode (SPAD), a PN photodiode, a PIN photodiode, a silicon photomultiplier (SiPM), and/or the like. Alternatively, direct band gap based detectors like InGaAs or alike could be used as well. As an example, detector 112 is configured to generate a first electrical signal (e.g., denoted as SigRx in Figure 1) based on at least optical signal 132. The term "electrical signal" may refer to an electrical representation of optical signal 132. The electrical signal is generated when the photon flux of the optical signal is converted into an electrical current by the detector. The electrical current may be sensed and converted into a voltage representation by the first stage of a frontend 114. The electrical signal may include a voltage that varies in amplitude and frequency depending on the characteristics of the optical signal. The electrical signal may include an analog representation that signifies a continuous-time signal that preserves the intricate variations in amplitude and temporal properties observed in optical signal 132, providing a rich data source for subsequent processing and analysis.

In various embodiments, detector 112 may be coupled to a frontend 114, which includes electrical components configured to perform one or more signal preprocessing steps (e.g., signal amplification, sampling, filtering, signal conditioning) to prepare the raw electrical signals for later processing and analysis. For instance, frontend 114 includes an amplifier configured to amplify the received optical signal 132 and provide an amplified signal for subsequent processing.

According to some embodiments, control module 124 (e.g., third circuit recited in claim 5) manages operations and various aspects of LIDAR system 100. As shown, control module 124 is coupled to driver 102 and is configured to send a control signal (e.g., electrical pulse or modulated waveform) to driver 102 and control the emission cycles of light source 104. For example, control module 124 may send a control signal to trigger light source 104 emitting light beam 106. Control module 124 allows for dynamic modulation of light beam attributes such as frequency, period, duration, pulse energy, peak power, average power, and wavelength. Depending on the implementation, control module 124 can be implemented using one or more microprocessors. In addition to providing a control signal to driver 102, control module 124 may send one or more signals to activate and manage other components of LIDAR system 100 to process received optical signals (e.g., optical signal 132).

As an example, LIDAR system 100 includes a comparator 116 (e.g., a first comparator recited in claim 1) coupled to detector 112 or frontend 114. The term "comparator" may refer to a device that compares two electrical signals and determines their relationship, such as equality, inequality, or magnitude difference. For instance, comparator 116 includes, but is not limited to, a voltage comparator, a current comparator, or others. In various examples, comparator 116 is configured to receive the first electrical signal and generate a second electrical signal by comparing the first electrical signal to a first threshold value. For instance, comparator 116 receives a first input threshold signal Xthres,0-characterized by the first threshold value-and compares the first electrical signal SigRx to the first threshold value. In some cases, the second electrical signal generated by comparator 116 may include a positive signal indicating when the comparison criteria are met (e.g., when the first electrical signal crosses the first threshold value).

Depending on the application, LIDAR system 100 may include multiple comparators, each of which is characterized by a certain threshold value. For instance, a comparator 126 (e.g., a second comparator recited in claim 2) may be coupled to detector 112 or frontend 114. Comparator 126 may receive a second input threshold signal Xthres,1-characterized by a second threshold value-and compare the first electrical signal SigRx to the second threshold value. Depending on the application, the threshold values associated with each comparator could be dynamically adjusted or statically set. For instance, the established threshold values can be configured to span the expected amplitude variations of the received optical signal 132. By employing multiple comparators with different thresholds, LIDAR system 100 enhances signal detection across a broad amplitude range, allowing for heightened sensitivity and reliability in diverse operational environments.

In various implementations, the second electrical signal generated by comparator 116 may be output to filter 118 (e.g., a first filter recited in claim 1). The term "filter" or "event filter" may refer to an electronic component designed to distinguish and discern specific events from a continuous or quasi-continuous input signal (e.g., the second electrical signal). In some embodiments, the events detected by filter 118 involve differentiating specific features or characteristics of the signal, such as identifying when the signal crosses a certain threshold in a specific direction. For example, filter 118 is configured to identify a rising event, which may refer to an instance where the second electrical signal rises above an associated threshold value (e.g., the first threshold value) in a positive or ascending direction (e.g., reaching the threshold from a lower value). Filter 118 is also configured to identify a falling event, which may refer to an instance where the second electrical signal falls below the same threshold value in a negative or descending direction (e.g., reaching the threshold from a higher value). In some cases, LIDAR system 100 further includes a filter 128 (e.g., a second filter recited in claim 3) coupled to comparator 126.

Upon identifying a specific condition (e.g., a rising event or falling event), filter 118 is configured to generate a third electrical signal based on at least the second electrical signal. The third electrical signal may include a first pulse that indicates the detected condition. For instance, in the case of a rising event, filter 118 may generate a first pulse comprising a rising pulse in response to the first electrical signal being higher than the first threshold value. The term "rising pulse" may refer to an edge of the electrical signal that is increasing in intensity. In the case of a falling event, filter 118 may generate a first pulse comprising a falling pulse in response to the first electrical signal being lower than the first threshold value. The term "falling pulse" may refer to an edge of the electrical signal that is decreasing in intensity. The first pulse captures both amplitude and temporal information about the event, providing rich data sets for subsequent signal processing and ToF calculations. In various examples, filter 118 is configured to determine a width of the first pulse. The terms "width" or "width of a pulse" may refer to the temporal extent or duration of a pulse. For instance, the width characterizes the time it takes for the first pulse to transition from a low or null state to its peak value and back to a low or null state. The width is crucial for capturing temporal information about the event that triggered the first pulse, such as the arrival of an optical signal or a specific change in an electrical signal.

In some embodiments, LIDAR system 100 further includes a circuit 120 (e.g., a second circuit recited in claim 1) coupled to filter 118. The fourth electrical signal may include an analog signal. The term "analog signal" may refer to a continuous-time electrical signal, which serves as a representation of the optical signal received by the LIDAR system. Circuit 120 may be configured to generate a fourth electrical signal based on at least the first pulse. For instance, circuit 120 may be coupled to memory 122 and can capture the time values contained in the first pulse and store them in the analog domain at memory 122. In an example, the first pulse includes a first point associated with a first timestamp, which may be temporarily stored within the analog domain at memory 122. The term "timestamp" may refer to a set of data or temporal markers indicating the precise temporal occurrence of an event (e.g., a rising or falling of the first pulse). The timestamps might, for example, be in the form of electrical charges or voltage levels that represent discrete points in time. It is to be appreciated that storing the timestamp "in the analog domain" implies that the temporal information, which represents the precise time occurrence of an event, remains in its continuous, unquantized form. This raw representation retains the intricate amplitude variations and temporal nuances observed in the original signal, thus capturing a rich data set that can be critical for accurate signal interpretation.

In various implementations, memory 122 may include one or more analog storage elements, such as capacitors or inductors. The term "analog storage element" refers to a device capable of temporarily retaining analog signals, which are continuous-time signals that can take any value within a defined range. The term "capacitor" refers to an electrical component that can store energy in the form of an electric field. It consists of two conductive plates separated by a dielectric material. When a voltage is applied to the capacitor, it charges up by storing electrons on one plate and creating a deficiency of electrons on the other plate. The term "inductor" refers to an electrical component that can store energy in the form of a magnetic field. It consists of a coil of wire. When a current flows through the inductor, it creates a magnetic field around the coil. Both capacitors and inductors can be used to store timestamps in the analog domain. For instance, a capacitor or inductor is used to create a circuit designed to delay the signal by a specific amount of time. The timestamp is then stored by measuring the delay time.

Depending on the implementation, the timestamps preserved in memory 122 may be further evaluated or processed in the analog domain or may remain stored for subsequent digitization. In some cases, at the start of each cycle-when the light beam is initiated-control module 124 may generate a start signal to reset the stored timestamps at memory 122. By storing the timestamp information temporarily in the analog domain, the system alleviates the time-sensitive constraints commonly associated with immediate digital conversion. Such an approach effectively eliminates the need for high-bandwidth data links and mitigates the operational intensity, thereby reducing overall power consumption and system latency.

According to various embodiments, control module 124 (e.g., third circuit recited in claim 5) may be coupled to memory 122 and configured to read the stored timestamps from memory 122. As an example, the term "read" or "readout" may refer to a function or capability of accessing, retrieving, or interpreting the stored temporal (e.g., the first timestamp). For instance, control module 124 may include a readout integrated circuit (ROIC) designed for reading/processing signals from memory 122. The read-out mechanism may involve the utilization of specific semiconductor components, such as Metal-Oxide-Semiconductor Field-Effect Transistors (MOSFETs), in conjunction with a bias current source. For instance, the MOSFETs could be actuated to enable a controlled current flow, thereby allowing for accurate and efficient retrieval of the stored analog time values, which can then be converted to a digital format for further processing.

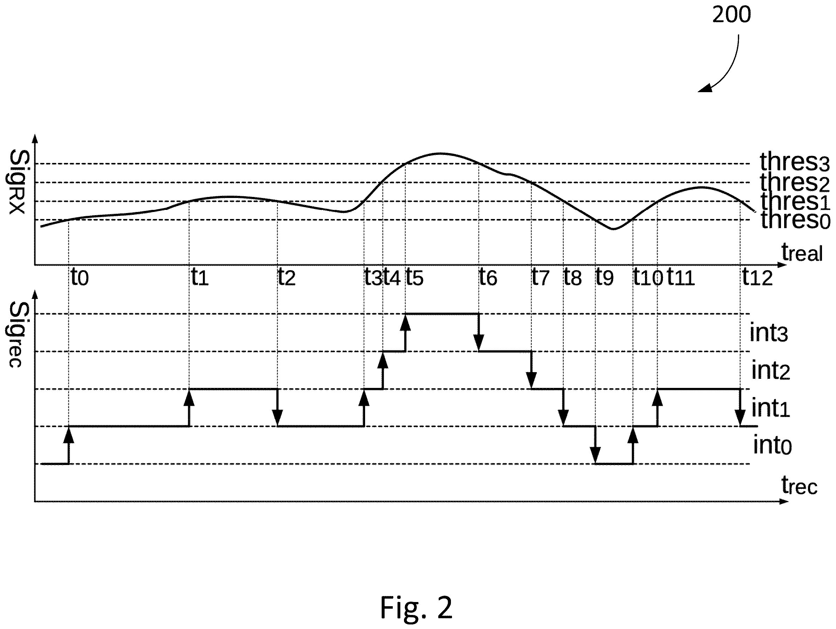

Figure 2 is a simplified diagram illustrating a signal processing scheme of a LIDAR system according to embodiments of the subject technology. This diagram merely provides an example, which should not unduly limit the scope of the claims. One of ordinary skill in the art would recognize many variations, alternatives, and modifications. As previously noted, a LIDAR system may adopt a plurality of threshold values for single interpretation. For instance, a LIDAR system may include a plurality of comparators (e.g., comparator 116 of Figure 1), each of which is associated with a threshold value. As shown in Figure 2, the signal SigRx represents the received optical signal, which is detected as a result of the interaction between the emitted light beam and the target. The amplitude of SigRx is compared against four threshold values, denoted as thres0, thres1, thres2, and thres3. The timestamps, denoted as t0, t1, ..., t12, indicate the times (on the x-axis) at which signal SigRx crosses one of the threshold values in a rising or falling direction. For instance, the signal SigRX passes through the threshold thres0 in a rising direction at a time t0, passes through the threshold thres1 in a rising direction at a time t1, passes through the threshold thres2 in a falling direction at a time t2, etc. By recording these events, LIDAR system can generate an electrical signal denoted as Sigrec (e.g., using filter 118 of Figure 1), which may include a first pulse. The amplitude of or the envelope of the first pulse may be determined by plotting the various threshold values at various timestamps.

Depending on the implementation, each of the timestamps may be temporarily stored within the analog domain using an analog storing element (e.g., capacitor, inductor). As shown in Figure 2, for instance, the LIDAR system may include a total of 13 analog storing elements to retain these timestamps (e.g., from t0 to 112). It is to be appreciated that the number of analog storing elements and specific values of associated thresholds may be determined based on the characteristics of the received signal and the operational requirements of the system. The goal is to minimize the data traffic required for subsequent digital conversion while ensuring high-fidelity temporal information for accurate distance measurement. Depending on the specific application and operational demands, the actual number of storing elements could exceed or be fewer than 13.

It is to be appreciated that the utilization of multiple threshold values enhances the LIDAR system's capacity for interpreting complex signal patterns, thereby increasing both the system's sensitivity and adaptability. This approach enables the LIDAR system to capture intricate details about the received optical signal, such as its shape, width, peak, and center, and/or the like. In certain embodiments, the LIDAR system can determine the distance to the target object based on the round-trip time taken for the optical signal to return and the known speed of light in the relevant medium (e.g., air). For example, such ToF calculations may use a timestamp (e.g., t0) associated with a first threshold value crossing on a rising edge and a timestamp (e.g., t2) associated with a second threshold value crossing on a falling edge to determine the pulse width of the received optical signal.

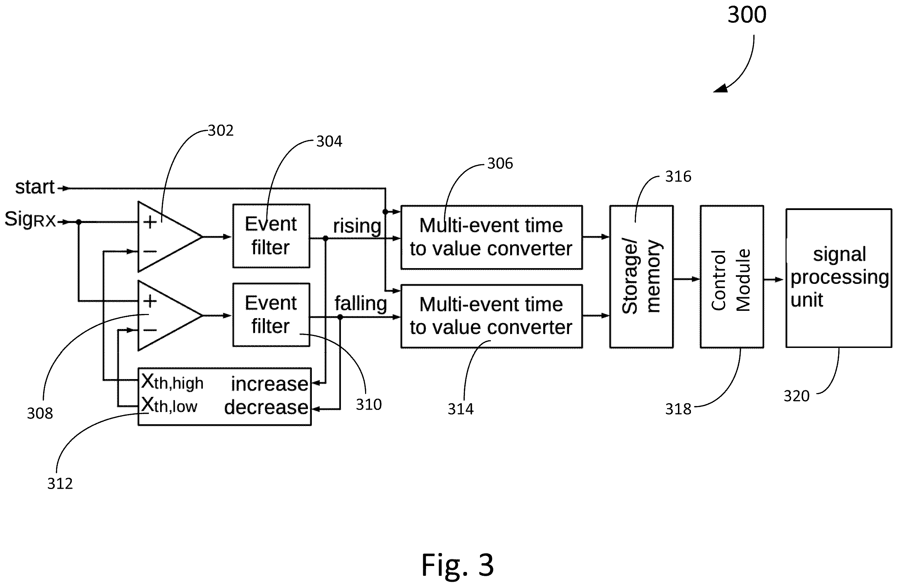

Figure 3 is a simplified diagram illustrating a signal processing scheme of a LIDAR system 300 according to embodiments of the subject technology. This diagram merely provides an example, which should not unduly limit the scope of the claims. One of ordinary skill in the art would recognize many variations, alternatives, and modifications. LIDAR system 300 may include one or more comparators with adjustable threshold values. In some embodiments, LIDAR system 300 includes a comparator 302 and a comparator 308. Comparator 302 may be associated with a first threshold value and comparator 308 may be associated with a second threshold value. Comparator 302 may be configured to receive a first electrical signal, denoted as SigRx, and generate a second electrical signal by comparing the first electrical signal to the first threshold value. Comparator 308 may be configured to receive the first electrical signal and generate a third electrical signal by comparing the first electrical signal to the second threshold value.

Depending on the application, the first and second threshold values-respectively denoted as $X_{th,\ high}$ and $X_{th,\ low}$-may be dynamically adjusted. For instance, LIDAR system 300 further includes a circuit 312 (e.g., a fourth circuit recited in claim 9) configured to adjust the first threshold value and/or the second threshold values. In an example, the first threshold value is greater than the second threshold value. As shown in Figure 3, the first threshold value is denoted as $X_{th,\ high}$, and the second threshold value is denoted as $X_{th,\ low}$. In operation, circuit 312 is configured to increase the first threshold value when the first electrical signal SigRx crosses the first threshold value in a rising direction and decrease the second threshold value when the first electrical signal SigRx crosses the second threshold value in a falling direction. The dynamic adjustment of threshold values effectively broadens the range of detectable signal variations without requiring additional comparators, thereby enhancing performance while minimizing system complexity.

Like LIDAR system 100, system 300 may further include a filter 304 coupled to comparator 302 and a filter 310 coupled to comparator 308. For instance, filter 304 is configured to generate a fourth electrical signal based on at least the second electrical signal. Filter 310 is configured to generate a fifth electrical signal based on at least the third electrical signal. Filter 304 and filter 310 may identify the events where the input signal crosses a certain threshold (e.g., the first and second threshold values) in a specific direction (e.g., a rising or falling direction) and generate the output based on such determination. In some embodiments, the fourth and fifth electrical signals contain temporal information associated with the detected events. For instance, the fourth electrical signal includes a first pulse, which includes a first point associated with a first timestamp. The fifth electrical signal includes a second pulse, which includes a second point associated with a second timestamp.

In various implementations, system 300 further includes a circuit 306 coupled to filter 304 and a circuit 314 coupled to filter 310. For example, circuit 306 is configured to generate a sixth electrical signal based on at least the first pulse. Circuit 314 is configured to generate a seventh electrical signal based on at least the second pulse. Memory 316 may be coupled to circuit 306 and circuit 314 and receives the sixth electrical signal and the seventh electrical signal. For instance, memory 122 may include one or more analog storage elements (e.g., a capacitor or inductor) and is configured to store the first and second timestamps within the analog domain.

Depending on the implementation, the timestamps preserved in memory 316 may be further evaluated or processed in the analog domain or may remain stored for subsequent digitization. In some cases, at the start of each cycle-when the light beam is initiated-control module 316 may generate a start signal to reset the stored timestamps at memory 316. In various examples, the timestamps stored at memory 316 may be read by control module 318 and processed by signal processing unit 320 for further processing and analysis (e.g., digital conversion, ToF calculation, etc.). For example, signal processing unit 320 includes an analog-to-digital converter (ADC), which is configured to produce a digital representation of a received signal.

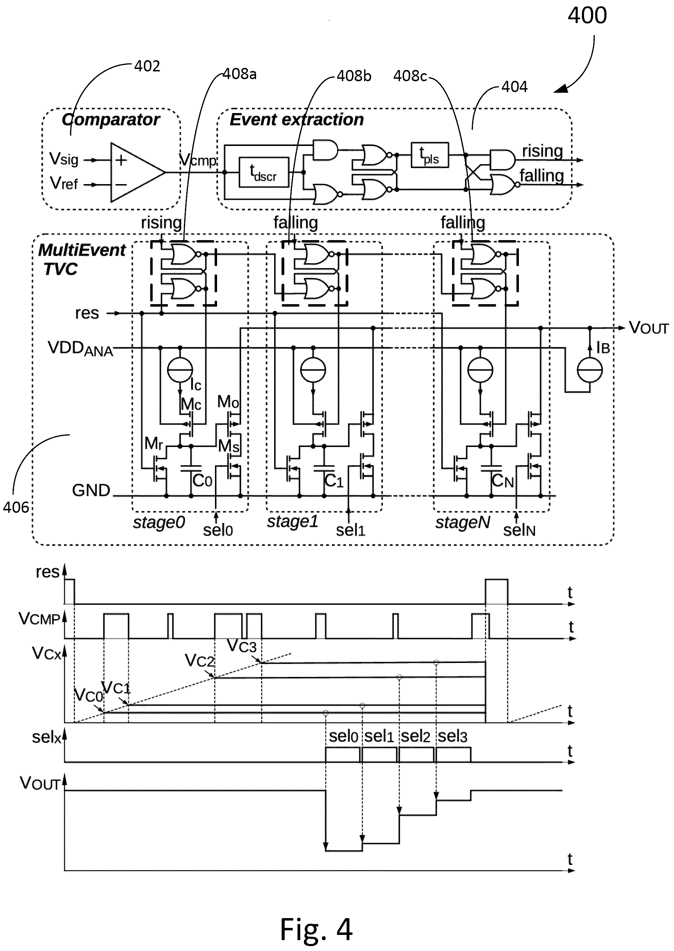

Figure 4 is a simplified diagram illustrating an analog implementation of a signal processing scheme of a LIDAR system 400 according to embodiments of the subject technology. This diagram merely provides an example, which should not unduly limit the scope of the claims. One of ordinary skill in the art would recognize many variations, alternatives, and modifications.

In various embodiments, LIDAR system 400 includes a comparator 402 configured to receive a first electrical signal Vsig and generate a second electrical signal by comparing the first electrical signal Vcmp to a first threshold value Vref. Comparator 402 may be coupled to a filter 404 and output the second electrical signal to filter 404. Filter 404 may be configured to distinguish the received signal from noise to ensure that only genuine signal pulses contribute to the timestamping process for ToF calculation. For example, filter 404 is configured to determine a minimum duration on the input signal (e.g., the second electrical signal Vcmp) to filter out transient pulses (e.g., the resultant from noise interferences). Filter 404 may also identify the events where the input signal crosses a certain threshold (e.g., the first threshold value) in a specific direction (e.g., a rising or falling direction) and generate a third electrical signal based on such determination. For instance, the third electrical signal includes a falling pulse in response to the first electrical signal being lower than the first threshold value and/or a rising pulse in response to the first electrical signal being higher than the first threshold value. In some cases, the third electrical signal may contain temporal information (e.g., the timestamps) associated with the detected events.

In various implementations, filter 404 is coupled to circuit 406 configured to receive the third electrical signal. Circuit 406 may further include one or more analog storing elements (e.g., a capacitor) configured to store the temporal information within the analog domain. For instance, circuit 406 includes a plurality of capacitors-denoted as $C_0$ through $C_N$-configured to store the temporal information. These capacitors are charged through a constant current Ic, and the voltage outputs from these capacitors, denoted as $V_{Cx}$, are proportional to the timestamps according to the following equation:

$$V_{Cx} = \frac{t_x \cdot I_C}{C_X}$$

where $t_x$ represents the time duration at which the capacitor was charged by the current Ic.

In some embodiments, circuit 406 further includes a plurality of cascaded RS flip-flops (e.g., RS flip-flops 408a, 408b, 408c) configured to ensure that different stages of circuit 406 respond to rising and falling pulses in a sequential manner. This sequencing is achieved by deactivating individual current sources upon the transition of each stage, creating a controlled, sequential response. Each operational cycle is initiated by a reset signal, labeled as 'res,' that discharges the capacitors through their respective Metal-Oxide-Semiconductor Field-Effect Transistors (MOSFETs) denoted as Mr, and resets the chain of RS flip-flops. Upon the emission of a light beam or any other initiating event, the 'res' signal is released. Following this, the capacitors start integrating the charges, proportional to the constant current Ic. Upon the detection of the first pulse, the RS flip-flop at stage 0 changes its state, leading to the deactivation of the charging current Mc. Consequently, the voltage across capacitor $C_0$ becomes proportional to the elapsed time between the falling edge of 'res' and the occurrence of the first pulse on 'rising.' The output of this first RS flip-flop further deactivates the subsequent stage, allowing it to respond to the next detected pulse, and so on. This sequence permits the acquisition and storage of timestamps for a maximum of N events in a sequential manner. The number of such storage elements, denoted as N, can vary according to specific application requirements. In various embodiments, readout of the stored timestamps may be performed via the MOSFETs denoted as $M_O$ and $M_S$ in combination with a bias current source.

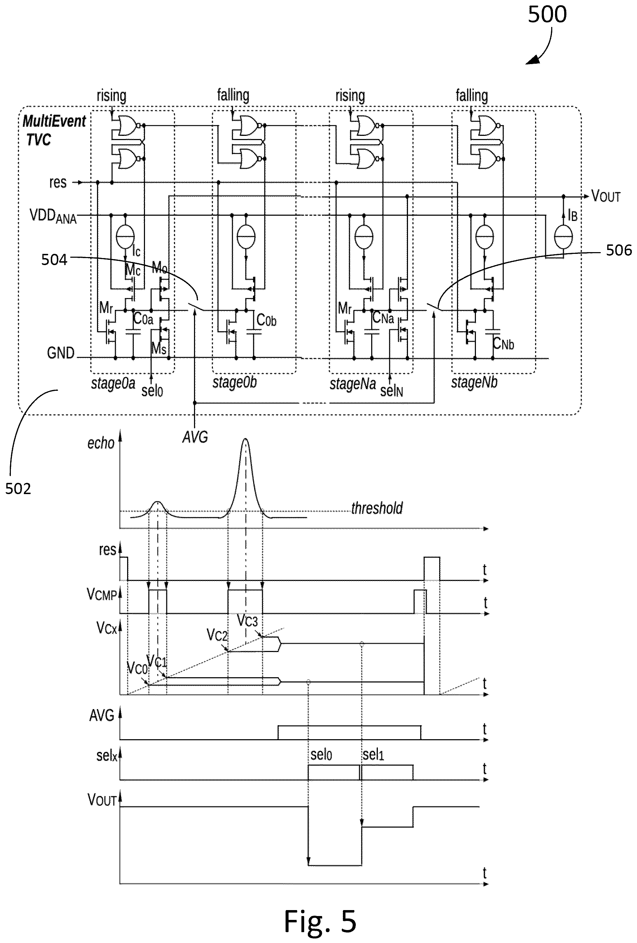

Figure 5 is a simplified diagram illustrating an analog implementation of a signal processing scheme of a LIDAR system 500 according to embodiments of the subject technology. This diagram merely provides an example, which should not unduly limit the scope of the claims. One of ordinary skill in the art would recognize many variations, alternatives, and modifications.

In various implementations, the reception of an optical signal in a LIDAR system-particularly when timestamping is based on a singular threshold crossing point-can produce time outputs susceptible to the slew rate or bandwidth variations of the received optical signal. This is especially pertinent when the threshold level for capturing the timestamp remains static, which may lead to systematic errors caused by varying external factors (e.g., target reflectivity) or weather conditions (e.g., rain or fog). To tackle this challenge, LIDAR system 500 implements a mechanism capable of capturing the timestamp associated with a peak of a pulse to compensate for the errors caused by the aforementioned slew rate variations.

In some embodiments, circuit 502 receives an input electrical signal from a filter (e.g., filter 404 of Figure 4). The input electrical signal may include a first pulse including a first point associated with a first timestamp and a second point associated with a second timestamp. For instance, the first timestamp indicates when the first pulse crosses a threshold value in a rising direction, and the second timestamp indicates when the first pulse crosses the threshold value in a falling direction. Circuit 502 may be configured to calculate a third timestamp associated with a third point of the first pulse. The third point may be positioned between the first point and the second point. In some cases, the third point is a peak point of the first pulse.

In operation, a control signal-denoted as AVG-may be activated to close the associated switches (e.g., switch 504, 506, etc.), which initiates a charge redistribution among the plurality of capacitors $C_0$ through $C_N$. For instance, the activation of the control signal AVG may be controlled by a control module (not shown). When equally sized capacitors are employed, the charge redistribution results in an average voltage that represents the timestamp (e.g., the third timestamp) associated with the peak point of the first pulse, allowing the circuit to effectively "look back" in time. By evaluating the average of two time measurements (e.g., the first and second timestamps), LIDAR system 500 effectively captures a more accurate and environmentally adaptive set of timestamps, thereby improving the robustness and accuracy of the system in various operating conditions.

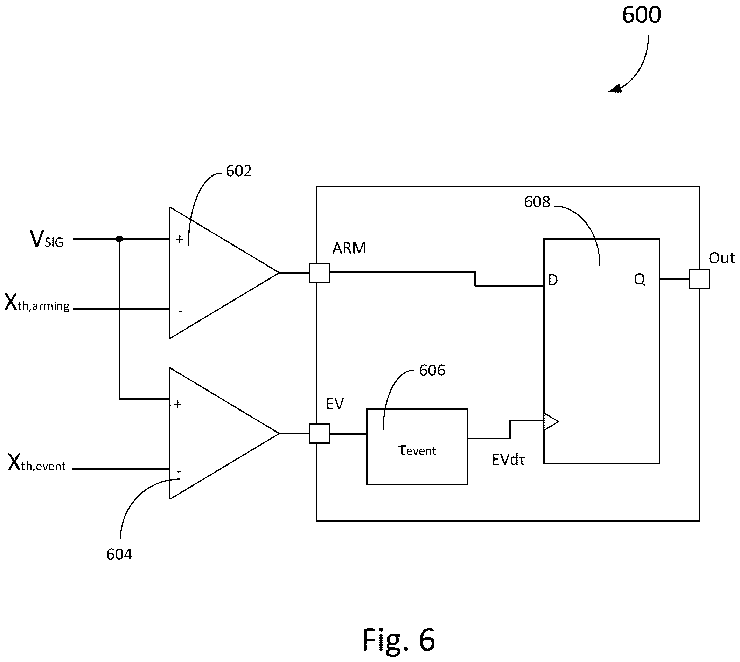

Figure 6 is a simplified diagram illustrating a filter of a LIDAR system 600 according to embodiments of the subject technology. This diagram merely provides an example, which should not unduly limit the scope of the claims. One of ordinary skill in the art would recognize many variations, alternatives, and modifications. In various implementations, LIDAR system 600 may adopt a comparator system configured for selective event detection based on slew rate characteristics of the input signal, denoted as $V_{SIG}$. The term "slew rate" may refer to the maximum rate of change of the signal's amplitude over time. As an example, LIDAR system 600 includes a first comparator 602 and a second comparator 604. First comparator 602 may be associated with a first threshold value, denoted as $X_{th,arming}$. Second comparator 604 may be associated with a second threshold value, denoted as $X_{th,event}$.

In operation, the second threshold value may be configured to be lower than the first threshold value, which ensures that the second comparator is the first to respond when an input signal $V_{SIG}$ is received. Accordingly, a first output signal generated by the second comparator 604-denoted as EV-may be output to circuit 606. Circuit 606 is configured to determine a minimum duration $\tau_{event}$ on the input signal. Depending on the implementation, the minimum duration $\tau_{event}$ may be adjusted based on a predetermined slew rate. In some embodiments, first comparator 602 is configured to compare the input signal $V_{SIG}$ to the first threshold value and generate a second output signal, denoted as ARM. The second output signal may be output to circuit 608, which may include a D-type flip flop. Circuit 608 may be clocked by the output of circuit 606, denoted as $EV_{d\tau}$. This arrangement ensures that the output of circuit 608 will only be active when the input signal's slew rate attains a voltage differential ($X_{th,arming}$ - $X_{th,event}$) within the designated timeframe $\tau_{event}$. While this document describes a two-point architecture for ease of understanding and simplicity, it is to be appreciated that the system's design advantageously supports slew rate detection at multiple points beyond the illustrated two, offering a more comprehensive analysis of the signal characteristics. LIDAR system 600 provides an effective mechanism for the dynamic selection of signals based on their slew rates. This effectively filters the input signals by allowing only those that meet specific slew rate conditions to pass, thereby enhancing the accuracy and reliability of the LIDAR system 600 under diverse environmental conditions.

While the above is a full description of the specific embodiments, various modifications, alternative constructions and equivalents may be used. Therefore, the above description and illustrations should not be taken as limiting the scope of the subject technology which is defined by the appended claims.

## Claims

1. A device, comprising:

   an optical module configured to receive a first optical signal;
   a first circuit coupled to the optical module, the first circuit being configured to generate a first electrical signal based on at least the first optical signal;
   a first comparator coupled to the first circuit, the first comparator being configured to generate a second electrical signal by comparing the first electrical signal to a first threshold value;
   a first filter coupled to the first comparator, the first filter being configured to generate a third electrical signal based on at least the second electrical signal, the third electrical signal comprising a first pulse, the first pulse comprising a first point associated with a first timestamp;
a second circuit coupled to the first filter, the second circuit being configured to generate a fourth electrical signal based on at least the first pulse; and
a memory configured to receive the fourth electrical signal and store the first timestamp.

2. The device of claim 1, further comprising

a second comparator coupled to the first circuit, the second comparator being configured to compare the first electrical signal to a second threshold value;
wherein in particular the device further comprises
a second filter coupled to the second comparator.

3. The device of claim 1 or 2, wherein
the memory comprises a capacitor or an inductor.

4. The device of any one of the claims 1 to 3, further comprising
a third circuit coupled to the memory, the third circuit being configured to read the first timestamp and to send a first signal to the second circuit to reset the memory.

5. The device of any one of the claims 1 to 4, wherein
the first pulse comprises a rising pulse in response to the first electrical signal being higher than the first threshold value.

6. The device of any one of the claims 1 to 5, wherein
the first pulse comprises a falling pulse in response to the first electrical signal being lower than the first threshold value.

7. The device of any one of the claims 1 to 6, wherein
the first filter is configured to determine a width of the first pulse.

8. The device of any one of the claims 1 to 7, further comprising
a fourth circuit coupled to the first comparator, the fourth circuit being configured to adjust the first threshold value.

9. The device of any one of the claims 1 to 8, wherein
the fourth electrical signal comprises an analog signal.

10. A device, comprising:

an optical module configured to receive a first optical signal;

a first circuit coupled to the optical module, the first circuit being configured to generate a first electrical signal based on at least the first optical signal;
a first comparator coupled to the first circuit, the first comparator being configured to generate a second electrical signal by comparing the first electrical signal to a first threshold value;
a first filter coupled to the first comparator, the first filter being configured to generate a third electrical signal based on at least the second electrical signal, the third electrical signal comprising a first pulse, the first pulse comprising a first point associated with a first timestamp;
a second circuit coupled to the first filter, the second circuit being configured to generate a fourth electrical signal based on at least the first pulse; and
a memory coupled to the second circuit, the memory being configured to receive the fourth electrical signal and store the first timestamp.

11. The device of claim 10, further comprising:

a second comparator coupled to the first circuit, the second comparator being configured to generate a fifth electrical signal by comparing the first electrical signal to a second threshold value; and
a second filter coupled to the second comparator, the second filter being configured to generate a sixth electrical signal based on at least the fifth electrical signal, the sixth electrical signal comprising a second pulse, the second pulse comprising a second point associated with a second timestamp.

12. The device of claim 11, further comprising
a fourth circuit coupled to the second filter, the fourth circuit being configured to generate a seventh electrical signal based on at least the second pulse;

wherein in particular
the memory is coupled to the fourth circuit, and the memory is configured to receive the seventh electrical signal and store the second timestamp.

13. The device of any one of the claims 10 to 12, further comprising
a fifth circuit coupled to the first comparator, the fifth circuit being configured to adjust the first threshold value.

14. A device, comprising:

an optical module configured to receive a first optical signal;

a first circuit coupled to the optical module, the first circuit being configured to generate a first electrical signal based on at least the first optical signal;

a first comparator coupled to the first circuit, the first comparator being configured to generate a second electrical signal by comparing the first electrical signal to a first threshold value;

a first filter coupled to the first comparator, the first filter being configured to generate a third electrical signal based on at least the second electrical signal, the third electrical signal comprising a first pulse, the first pulse comprising a first point and a second point, the first point being associated with a first timestamp, the second point being associated with a second timestamp;

a second circuit coupled to the first filter, the second circuit being configured to generate a fourth electrical signal based on at least the first pulse; and

a memory configured to receive the fourth electrical signal and store a third timestamp based on at least the first timestamp and the second timestamp.

15. The device of claim 14, comprising at least one of the following features:

(A) the first pulse further comprises a third point positioned between the first point and the second point, the third point is associated with the third timestamp;

(B) the memory comprises a capacitor or an inductor;

(C) further comprising a third circuit coupled to the memory, the third circuit being configured to read the third timestamp; and

(D) the fourth electrical signal comprises an analog signal.

Fig. 1

Fig. 2

Fig. 3

Fig. 4

Fig. 5

Fig. 6

EP 4 549 996 A1

Europäisches
Patentamt

European
Patent Office

Office européen
des brevets

# EUROPEAN SEARCH REPORT

Application Number

EP 24 19 9782

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 10 2021 101790 A1 (OSRAM GMBH [DE]) 28 July 2022 (2022-07-28) * paragraphs [0020] - [0153] * * figures 1-3 * ----- | 1-15 | INV. G01S7/4865 G01S7/487 G01S17/10 G01S7/4861 |
| A | US 2018/284247 A1 (CAMPBELL SCOTT R [US] ET AL) 4 October 2018 (2018-10-04) * paragraphs [0027] - [0144] * * figures 1-19 * ----- | 1,10,14 | |

TECHNICAL FIELDS
SEARCHED     (IPC)

G01S

The present search report has been drawn up for all claims

| Place of search | Date of completion of the search | Examiner |
|---|---|---|
| Munich | 18 February 2025 | Kruck, Peter |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
...........................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 19 9782

This annex lists the patent family members relating to the patent documents cited in the above-mentioned European search report.
The members are as contained in the European Patent Office EDP file on
The European Patent Office is in no way liable for these particulars which are merely given for the purpose of information.

18-02-2025

| Patent document cited in search report | Publication date | Patent family member(s) | Publication date |
|---|---|---|---|
| DE 102021101790 A1 | 28-07-2022 | CN 116745639 A | 12-09-2023 |
| | | DE 102021101790 A1 | 28-07-2022 |
| | | US 2024142584 A1 | 02-05-2024 |
| | | WO 2022161702 A1 | 04-08-2022 |
| US 2018284247 A1 | 04-10-2018 | NONE | |

EPO FORM P0459

For more details about this annex : see Official Journal of the European Patent Office, No. 12/82